# DEMANDE DE BREVET EUROPEEN

(11) **EP 3 632 845 A1**
(43) Date de publication de la demande: **08.04.2020**
(21) Numéro de dépôt: 19200337.4
(22) Date de dépôt: 30.09.2019
(51) Int. Cl.: C01B 32/158, C23C 16/26, C23C 16/455, C23C 16/02, H01B 1/04, C30B 25/18, C30B 29/02, C30B 29/60

(54) **EMPILEMENT MULTICOUCHE POUR LA CROISSANCE PAR CVD DE NANOTUBES DE CARBONE**

(30) Priorité: 01.10.2018 FR 1859070
(71) Demandeur: Commissariat à l'Energie Atomique et aux Energies Alternatives, 75015 Paris (FR)
(72) Inventeur: DINI, Yoann, 38054 GRENOBLE Cedex 09 (FR); DIJON, Jean, 38054 GRENOBLE Cedex 09 (FR)
(74) Mandataire: Nony

(57) **Abrégé**

L'invention a pour objet l'utilisation, à titre de sous-couche support du catalyseur dans un procédé de croissance de nanotubes de carbone par dépôt chimique en phase gazeuse (CVD), d'un empilement multicouche (1) formé de couches alternées de silice (12) et d'alumine (11), chacune des couches présentant une épaisseur inférieure ou égale à 10 nm et étant constituée d'une ou plusieurs monocouche(s) atomique(s) superposée(s).

Elle concerne encore une structure multicouche (2) comportant un substrat (10) muni sur au moins l'une de ses faces d'un tel empilement multicouche, ainsi que sa mise en œuvre pour la croissance d'un tapis de nanotubes de carbone, en particulier filables, par dépôt chimique en phase vapeur, de préférence activée par filament(s) chaud(s).

## Description

La présente invention concerne une nouvelle méthode de préparation par dépôt chimique en phase gazeuse (CVD) d'un tapis de nanotubes de carbone, avantageusement filables, présentant d'excellentes propriétés électriques. Elle se rapporte plus particulièrement à la mise en œuvre d'une nouvelle sous-couche support du catalyseur, pour la croissance des nanotubes de carbone par CVD.

Les tapis de nanotubes de carbone (NTC), dits « filables », trouvent une application particulièrement intéressante dans la fabrication de films 2D (encore appelés « nappes ») et de fils (ou câbles) en nanotubes de carbone [1]. Les nappes présentent un intérêt pour des applications optiques et optoélectroniques, par exemple dans la préparation d'électrodes transparentes conductrices. Les bonnes propriétés électriques, mécaniques et thermiques des câbles à base de nanotubes de carbone en font des matériaux de choix pour la substitution des métaux dans certains domaines applicatifs, tels que dans l'aéronautique et l'aérospatiale.

Les tapis de nanotubes de carbone sont typiquement préparés par une technique de dépôt chimique en phase gazeuse (CVD pour « Chemical Vapor Déposition » en langue anglaise). Le principe de la méthode de croissance des NTC par CVD consiste à injecter, dans un four à haute température, un gaz carboné, précurseur des nanotubes de carbone, généralement de l'acétylène ou de l'éthylène, sur un catalyseur de fer préalablement déposé sur une sous-couche supportée par un substrat de base. A haute température, la fine couche de fer, d'épaisseur nanométrique, démouille pour former des nanoparticules. Au contact d'une nanoparticule de fer, l'hydrocarbure craque pour former un nanotube de carbone sur le dessus de la particule de fer. Les nanotubes de carbone croissent ainsi verticalement et s'arrangent entre eux sous la forme d'une « forêt », encore appelée « tapis », de nanotubes de carbone. Plus de 10 milliards de nanotubes peuvent être ainsi formés par cm² d'échantillon.

Dans certains rares cas, les tapis de nanotubes sont arrangés de telle façon qu'en tirant sur un flanc du tapis, les nanotubes de carbone peuvent se débobiner pour former une nappe 2D de nanotubes de carbone. Cette nappe peut être utilisée telle quelle, ou encore sous une forme torsadée, pour former un câble. La capacité d'un tapis de nanotubes de carbone à former une nappe est appelée « filabilité ». Celle-ci est sensible à plusieurs paramètres, tels que la nature de la sous-couche sur laquelle est déposé le catalyseur, l'épaisseur de la couche catalytique, la température ou encore la nature de la phase gazeuse au cours du procédé de CVD.

A titre de sous-couches, supportant le catalyseur pour la croissance de nanotubes organisés sous la forme de tapis filables, ont déjà été proposées, d'une part, une sous-couche d'alumine [2], d'autre part une sous-couche de silice [3]. Malheureusement, chacune des méthodes proposées présentent des inconvénients.

Ainsi, les performances électriques des câbles, fabriqués avec des tapis de NTC obtenus à partir d'une sous-couche d'alumine, sont inférieures à celles obtenues pour des tapis de NTC fabriqués à partir d'une sous-couche de silice. La conductivité maximale, répertoriée dans la littérature, pour l'alumine est de 600 S/cm, tandis qu'elle est de 1000 S/cm pour la silice. Également, la croissance par CVD de nanotubes à partir d'une sous-couche d'alumine est opérée à une température de 750 °C, alors que celle réalisée à partir d'une sous-couche de silice, peut être avantageusement obtenue à de plus faibles températures (660°C).

D'un autre côté, la mise en œuvre d'une sous-couche d'alumine pour la préparation des tapis de NTC, présente l'avantage de conduire à des nanotubes de plus petits diamètres. Typiquement, le diamètre des nanotubes de carbone, permettant d'obtenir des tapis filables, est de l'ordre de 8,5 nm pour une croissance réalisée à partir d'une sous-couche en alumine, tandis qu'il est d'environ 16 nm dans le cadre de la mise en œuvre d'une sous-couche en silice. Il est connu par ailleurs que, pour les nanotubes de carbone multi-feuillets, la résistance du nanotube, lorsqu'il est contacté par le flanc, comme dans le cas de la préparation d'une nappe ou d'un câble en nanotubes, est indépendante de son diamètre [4]. Afin d'avoir un câble avec la plus faible résistance possible, il faut donc mettre un maximum de nanotubes de carbone en parallèle par unité de section. Ceci est possible en disposant de nanotubes de carbone présentant le plus faible diamètre possible.

Ainsi, il serait souhaitable de disposer d'une méthode de préparation d'un tapis de nanotubes de carbone, avantageusement filables, permettant de combiner les avantages propres à chacune des méthodes déjà proposées pour la croissance de tapis de NTC filables.

Plus particulièrement, il demeure un besoin de disposer d'une méthode de préparation de nanotubes de carbone, permettant d'accéder, à des basses températures, à des tapis de nanotubes de carbone filables, composés de nanotubes de faibles diamètres, tout en présentant des propriétés électriques optimales.

La présente invention vise précisément à répondre aux exigences précitées.

Plus précisément, les inventeurs ont constaté qu'il est possible d'accéder à un tapis de nanotubes de carbone, répondant aux critères précités, en mettant en œuvre, à titre de sous-couche supportant le catalyseur de la croissance des nanotubes de carbone par CVD, un empilement multicouche formé d'une succession alternée de couches atomiques de deux oxydes différents, l'alumine et la silice.

La présente invention concerne ainsi, selon un premier de ses aspects, l'utilisation, à titre de sous-couche support du catalyseur dans un procédé de croissance de nanotubes de carbone par dépôt chimique en phase gazeuse (CVD), d'un empilement multicouche formé de couches alternées de silice et d'alumine, chacune des couches présentant une épaisseur inférieure ou égale à 10 nm et étant constituée d'une ou plusieurs monocouches atomiques superposées.

Comme détaillé dans la suite du texte, l'empilement multicouche selon l'invention peut être supporté, de manière classique, par un support de base, et revêtu sur sa face opposée au substrat, d'une couche de matériau(x) catalyseur(s) de la croissance de nanotubes de carbone, dite « couche catalytique », par exemple une couche en fer.

Ainsi, l'invention concerne encore une structure multicouche comportant un substrat muni sur au moins l'une de ses faces d'un empilement multicouche tel que défini précédemment, et plus particulièrement revêtu sur sa face opposée au substrat, d'une couche catalytique.

Comme illustré dans les exemples qui suivent, la mise en œuvre d'une telle structure multicouche permet de conduire, par une technique de dépôt chimique en phase vapeur, de préférence activée par filaments chauds, à la formation d'un tapis de nanotubes de carbone, avantageusement d'un tapis de nanotubes de carbone filables, présentant d'excellentes propriétés de conductivité électrique.

Ainsi, selon un autre de ses aspects, l'invention concerne un procédé de croissance d'un tapis de nanotubes de carbone, de préférence d'un tapis de nanotubes de carbone filables, comprenant au moins les étapes consistant en :
(i) disposer d'un substrat muni sur au moins l'une de ses faces d'un empilement multicouche formé de couches alternées de silice et d'alumine, tel que défini précédemment, ledit empilement multicouche étant revêtu en surface d'une couche catalytique ; et
(ii) procéder à la croissance, en surface de la couche catalytique, d'un tapis de nanotubes de carbone, selon une technique de dépôt chimique en phase vapeur (CVD), de préférence assistée par filament(s) chaud(s).

Elle concerne encore un ensemble, tel qu'obtenu à l'issue du procédé de croissance par CVD précité, comportant une structure multicouche telle que décrite précédemment, revêtue d'un tapis de nanotubes de carbone.

Par « tapis de nanotubes de carbone », on entend désigner, au sens de l'invention, une couche de nanotubes de carbone, sensiblement parallèles entre eux, orientés perpendiculairement à la structure multicouche selon l'invention, et dont l'épaisseur est proche de la longueur unitaire des nanotubes.

Un tapis selon l'invention de nanotubes de carbone, notés « NTC » dans la suite du texte, présente plus particulièrement une densité élevée en nanotubes de carbone, en particulier une densité supérieure ou égale à 10¹⁰ nanotubes par cm² et plus particulièrement comprise entre 10¹⁰ et 10¹³ nanotubes par cm².

Par tapis de nanotubes de carbone « filables », on entend désigner la capacité du tapis de nanotubes à être déformé pour former une nappe 2D, et par la suite, un câble, de nanotubes de carbone. On parle également de « filabilité » du tapis de NTC.

De manière avantageuse, un tapis de nanotubes de carbone obtenu selon l'invention, présente d'excellentes propriétés de conductivité électrique. Ainsi, la conductivité des câbles fabriqués à partir des tapis de NTC réalisés selon l'invention est avantageusement supérieure ou égale à 600 S/cm, en particulier d'environ 926 S/cm.

Également, les nanotubes de carbone obtenus selon l'invention présentent avantageusement de faibles diamètres, en particulier un diamètre moyen inférieur ou égal à 13 nm, de préférence inférieur ou égal à 8 nm.

Ainsi, de manière avantageuse, la mise en œuvre d'un empilement multicouche selon l'invention, comme sous-couche support au catalyseur pour la croissance par CVD des nanotubes de carbone, permet d'accéder à un tapis de NTC combinant à la fois de bonnes propriétés de filabilité et de très bonnes performances électriques.

D'autre part, de manière avantageuse, comme illustré dans les exemples qui suivent, il est possible, *via* la mise en œuvre d'une technique de CVD assistée par filament(s) chaud(s), de préférence par une grille de filaments chauds en carbone, de procéder à la synthèse d'un tel tapis de NTC filables, dans des conditions de basses températures, en particulier abaissées jusqu'à 630 °C, et donc avantageusement inférieures aux températures mises en œuvre pour les procédés, proposés jusqu'à présent, typiquement supérieures à 660 °C, et en moyenne supérieures à 730 °C.

Selon une variante de réalisation particulièrement avantageuse, la croissance des NTC à partir d'une multicouche selon l'invention est opérée par une technique de CVD assistée par filaments chauds, dans des conditions de basse pression, en particulier inférieure ou égale à 10 mbar, et de basse température, en particulier inférieure ou égale à 650 °C.

Enfin, de manière avantageuse, comme détaillé dans la suite du texte, les inventeurs ont montré qu'il est possible d'ajuster les paramètres de croissance des NTC au cours du procédé par CVD assisté par filament(s) chaud(s), en faisant varier au cours de la croissance des NTC, l'apport en carbone en surface du catalyseur et/ou la puissance du ou des filament(s).

L'invention pourra être mieux comprise à la lecture de la description détaillée qui va suivre, donnée en référence aux dessins annexés sur lesquels :
- la figure 1 représente, de manière schématique et en coupe transversale, un substrat (10) revêtu d'un empilement multicouche (1) selon l'invention, formé de couches alternées de silice (12) et d'alumine (11), et supportant une couche (13) catalytique de la croissance de NTC. Le zoom d'une partie de l'empilement multicouche (1) représente, de manière schématique, la constitution de chacune des couches de silice et d'alumine, formées respectivement d'une ou plusieurs monocouches atomiques.
- la figure 2 représente, de manière schématique et en coupe transversale, les trois variantes d'empilement multicouche selon l'invention, formé de couches alternées de silice (SiO₂) et d'alumine (Al₂O₃), testées dans les exemples ;
- la figure 3 est une photographie par microscopie électronique à balayage (MEB) d'un tapis de NTC filable obtenu selon l'invention ;
- la figure 4 représente, de manière schématique et partielle, un réacteur expérimental, tel que mis en œuvre dans les exemples, pour la croissance par CVD, assistée par une grille (32) de filaments chauds ;
- la figure 5 est une photographie d'une grille de filaments en carbone mise en œuvre pour la croissance par CVD ;
- la figure 6 est le chronogramme du procédé de croissance des NTC opéré en exemples, avec (1) la puissance des filaments chauds et (2) la température de la sole du réacteur sur laquelle repose les échantillons ;
- la figure 7 est un histogramme de la distribution du diamètre des NTC des tapis obtenus à l'aide de la première variante d'empilement multicouche testée dans les exemples.

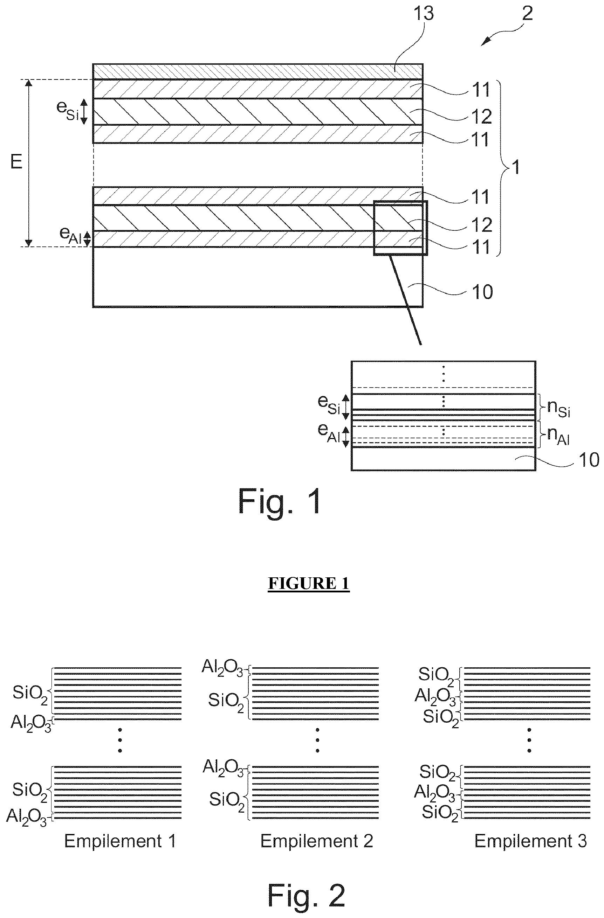

Il convient de noter que, pour des raisons de clarté, les différents éléments sur les figures 1, 2 et 4, sont représentés en échelle libre, les dimensions réelles des différentes parties n'étant pas respectées.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant un(e) » doit être comprise comme « comprenant au moins un(e) ».

### EMPILEMENT MULTICOUCHE SELON L'INVENTION

Comme évoqué précédemment, l'invention met en œuvre, à titre de sous-couche supportant le catalyseur pour la croissance par CVD de nanotubes de carbone, un empilement multicouche formé de couches alternées de silice (SiO₂) et d'alumine (Al₂O₃).

Des variantes de réalisation d'un empilement multicouche selon l'invention sont représentées, de manière schématique, en figures 1 et 2 suivantes.

Chacune des couches de silice (respectivement, d'alumine) de l'empilement multicouche selon l'invention est formée elle-même d'une ou plusieurs monocouche(s) atomique(s) de silice (respectivement, d'alumine).

Un empilement multicouche selon l'invention peut comprendre un nombre de couches de silice, noté N_{Si}, allant de 1 à 500, chacune des couches de silice étant elle-même formées d'une ou plusieurs monocouches atomiques de silice.

De même, il peut comprendre un nombre de couches d'alumine, noté N_{Al}, allant de 1 à 500, chacune des couches d'alumine étant elle-même formée d'une ou plusieurs monocouches atomiques d'alumine.

L'empilement selon l'invention étant formé d'une succession alternée de couches d'alumine et de silice, il est entendu que N_{Si}=N_{Al}, N_{Si}=N_{Al}-1 ou N_{Si}=N_{Al}+1.

De préférence, les couches de silice, formées d'une ou plusieurs monocouches atomiques de silice, présentent, indépendamment les unes des autres, une épaisseur (notée e_{Si}) comprise entre 0,01 et 10 nm, en particulier entre 0,1 et 10 nm et plus particulièrement entre 0,1 et 2 nm.

De même, les couches d'alumine (12), formées d'une ou plusieurs monocouches atomiques d'alumine, présentent, indépendamment les unes des autres, une épaisseur (notée e_{Al}) comprise entre 0,01 et 10 nm, en particulier entre 0,1 et 10 nm et plus particulièrement entre 0,1 et 2 nm.

Le nombre total de couches de silice et d'alumine formant un empilement multicouche selon l'invention est plus particulièrement ajusté au regard de l'épaisseur souhaitée pour l'empilement multicouche selon l'invention.

Le nombre total de couches d'un empilement multicouche selon l'invention est d'au moins trois, en particulier d'au moins dix, voire d'au moins quinze.

Un empilement multicouche selon l'invention, formé de la succession des couches superposées de silice et d'alumine, présente, de préférence, une épaisseur totale, notée E, comprise entre 5 nm et 50 nm, en particulier entre 7 nm et 20 nm, et plus particulièrement entre 8 nm et 12 nm.

Les couches de silice d'un empilement multicouche selon l'invention peuvent être formées, indépendamment les unes des autres, d'un nombre (noté n_{Si}) de monocouche(s) atomique(s) de silice compris entre 1 et 500, en particulier entre 10 et 500.

De même, les couches d'alumine d'un empilement multicouche selon l'invention peuvent être formées, indépendamment les unes des autres, d'un nombre (noté n_{Al}) de monocouche(s) atomique(s) d'alumine, compris entre 1 et 500, en particulier entre 10 et 500.

A titre d'exemple, les couches de silice des empilements multicouches 1 et 2, schématisés en Figure 2, présentent chacune neuf couches unitaires atomiques de silice, tandis que les couches d'alumine sont formées d'une unique couche unitaire atomique d'alumine.

Par l'expression « indépendamment les unes des autres », on entend signifier que le nombre de couches atomiques de silice (respectivement d'alumine) peut différer d'une couche de silice (respectivement d'alumine) à une autre.

Ainsi, par exemple, pour l'empilement multicouche 3 schématisé en Figure 2, les couches de silice présentent alternativement quatre et cinq couches unitaires atomiques de silice.

Les monocouches atomiques, dites encore « couches unitaires », de silice et/ou d'alumine peuvent présenter une épaisseur comprise entre 0,01 nm et 0,5 nm, en particulier entre 0,05 nm et 0,2 nm.

Le nombre de monocouches atomiques de silice et d'alumine des couches alternées de silice et d'alumine, dans un empilement multicouche selon l'invention, peut être plus particulièrement ajusté au regard des proportions souhaitées en silice et en alumine dans l'empilement multicouche.

Selon un mode de réalisation particulier, un empilement multicouche selon l'invention présente un ratio molaire silice/alumine compris entre 1 et 99, en particulier compris entre 2 et 50, et plus particulièrement compris entre 5et 15.

A titre d'exemple, les empilements multicouches, testés dans les exemples et schématisés en Figure 2, présentent un ratio molaire silice/alumine de 9.

Comme illustré dans les exemples qui suivent, les inventeurs ont découvert que la distribution des monocouches atomiques de silice et d'alumine au sein de l'empilement multicouche selon l'invention influe sur les propriétés des nanotubes obtenus à l'issue de la croissance par CVD.

En particulier, le nombre de monocouches atomiques constituant chacune des couches alternées de silice et d'alumine, ou encore la nature de la couche supérieure, sous-jacente à la couche catalytique, dans un empilement multicouche selon l'invention, influent sur les caractéristiques, notamment en termes de longueur, des nanotubes obtenus à l'issue de la croissance par CVD.

Ainsi, de manière avantageuse, la distribution des couches atomiques dans un empilement multicouche selon l'invention peut être avantageusement ajustée pour contrôler les dimensions des nanotubes de carbone obtenus.

### Préparation de l'empilement multicouche SiO₂/Al₂O₃

Un empilement multicouche selon l'invention peut être préparé par dépôts successifs de monocouches atomiques de silice et d'alumine en surface d'un substrat de base.

L'invention concerne ainsi, selon encore un autre de ses aspects, une structure multicouche, comportant un substrat muni sur au moins l'une de ses faces d'un empilement multicouche selon l'invention.

Elle concerne encore un procédé de préparation d'une telle structure multicouche, comprenant le dépôt, en surface d'un substrat de base, de monocouches successives atomiques de silice et d'alumine.

Le procédé peut plus particulièrement comprendre le dépôt, sur la face de l'empilement multicouche opposée au substrat de base, d'une couche de matériau(x) catalyseur(s) de la croissance de NTC.

Dans le cadre de l'invention, le terme « substrat » fait référence à une structure de base solide sur une des faces de laquelle est formé l'empilement multicouche selon l'invention.

Le substrat de base peut être de diverses formes et natures.

Il est entendu que la nature de ce substrat est choisie pour son inertie chimique lors des conditions opératoires du procédé de synthèse des NTC par la technique CVD, comme détaillé dans la suite du texte. Avantageusement, ce substrat est inorganique. Il peut être choisi parmi le silicium, l'alumine, un charbon actif, la silice, un silicate, la magnésie, l'oxyde de titane, la zircone, une zéolithe ou encore des fibres de carbone.

Par exemple, il s'agit d'une plaquette ou « wafer » de silicium.

La préparation d'un empilement multicouche selon l'invention, tel que défini précédemment, comprend plus particulièrement les étapes suivantes :
(i) former successivement n_{Si} monocouches atomiques de silice ;
(ii) former successivement n_{Al} monocouches atomiques d'alumine ;

les étapes (i) et (ii) étant opérées dans cet ordre ou dans l'ordre inverse, et répétées un nombre de fois suffisant pour former l'empilement multicouche souhaité formé de l'alternance de couches de silice et d'alumine.

Les différentes monocouches atomiques successives de silice et d'alumine peuvent être plus particulièrement formées par une technique de dépôt de couches atomiques (« Atomic Layer Déposition » ou « ALD »).

L'homme du métier est à même d'ajuster les paramètres de mise en œuvre de la méthode par ALD pour procéder au dépôt des couches atomiques souhaitées.

Avantageusement, le dépôt des couches de silice et d'alumine est réalisé dans une enceinte sous vide.

Le substrat pendant le dépôt des couches successives peut être maintenu à une température comprise entre 100 °C et 400 °C.

Un cycle de dépôt d'une couche atomique « ALD » en oxyde de métal tel que l'alumine ou en oxyde de métalloïde tel que la silice, comprend généralement :
- l'exposition de la surface du substrat, préalablement chauffé, à un précurseur contenant le métal ou le métalloïde de l'oxyde de métal ou de métalloïde à former.

Dans le cas de la formation d'une monocouche atomique en silice, le précurseur contiendra du silicium ; dans le cas de la formation d'une monocouche atomique en alumine, le précurseur contiendra de l'aluminium. Ces précurseurs sont généralement des composés organométalliques de métal ou métalloïde. Les précurseurs de la silice et de l'alumine sont respectivement le 3-aminopropyltriéthoxysilane (APTES) et triméthylaluminum (TMA)

La durée de l'exposition de la surface du substrat au précurseur doit être suffisante pour saturer la surface du substrat avec le précurseur.
- une étape de mise sous vide. Lors de cette étape, le substrat est maintenu pendant une certaine durée sous vide, sans exposition de la surface du substrat au précurseur.

Cette étape permet de laisser le temps aux molécules du précurseur en excès de se désorber de la surface du substrat et d'être évacuées par le pompage.
- exposition de la surface du substrat à l'eau.

Cette étape permet d'oxyder les molécules de précurseur pour former une monocouche d'oxyde de silice (SiO₂) ou d'alumine (Al₂O₃).
- une étape de mise sous vide. Lors de cette étape, le substrat et la monocouche d'oxyde sont maintenus pendant une certaine durée sous vide, sans exposition de la surface du substrat à de l'eau. Cette étape permet d'évacuer l'excès de molécules d'eau.

Ce cycle est répété pour former les différentes monocouches atomiques de silice et d'alumine et atteindre l'épaisseur souhaitée pour chacune des couches de silice et d'alumine alternées de l'empilement multicouche selon l'invention.

### Couche catalytique

Comme indiqué précédemment, l'empilement multicouche selon l'invention sert de sous-couche supportant le catalyseur de la croissance des nanotubes de carbone.

Ainsi, une structure multicouche, utile pour la croissance par CVD de nanotubes de carbone, comporte, en surface de l'empilement multicouche selon l'invention, une couche de matériau(x) catalyseur(s) de la croissance de NTC, dite couche catalytique.

Les matériaux catalyseurs de la croissance des nanotubes de carbone sont bien connus de l'homme du métier. Ils peuvent par exemple être choisis parmi le fer (Fe), le chrome (Cr), le nickel (Ni), le cobalt (Co), le palladium (Pd), ainsi que parmi tous les alliages binaires, ternaires ou quaternaires entre ces métaux.

De préférence, la couche catalytique est une couche en fer.

Le dépôt de la couche catalytique en surface de l'empilement multicouche selon l'invention peut être opéré par toute technique connue de l'homme du métier, par exemple par évaporation par canon à électron.

La couche catalytique, sus-jacente à l'empilement multicouche selon l'invention, peut présenter une épaisseur comprise entre 0,3 nm et 5 nm, en particulier entre 0,5 nm et 3 nm, et plus particulièrement entre 1 et 2 nm.

Comme représenté schématiquement en figure 1, une structure multicouche (2) selon l'invention, utile pour la croissance par CVD des nanotubes de carbone, peut ainsi comporter, dans cet ordre de superposition :
- un substrat de base (10), par exemple un substrat en silice ;
- un empilement multicouche (1), portée par le substrat, formé de couches alternées d'alumine (11) et de silice (12) selon l'invention, tel que détaillé ci-dessus ; et
- une couche (13), portée par l'empilement multicouche, à base de matériau(x) catalyseur(s) de la croissance de NTC.

Le matériau catalyseur est plus particulièrement mis en œuvre, lors du procédé de croissance des NTC par CVD, sous sa forme réduite. Celle-ci est généralement obtenue en exposant la couche catalytique au sein du réacteur CVD, à de l'hydrogène. De cette façon, le matériau catalyseur est réduit *in situ* dans le réacteur CVD, et la couche catalytique n'est pas oxydée lors de la mise en œuvre de la structure multicouche pour la croissance des NTC.

### PROCEDE DE CROISSANCE CVD

Le tapis de nanotubes de carbone est formé par croissance des nanotubes de carbone par une technique de dépôt chimique en phase vapeur (acronyme anglais CVD de « Chemical Vapor Deposition »), à la surface d'une structure multicouche telle que décrite précédemment, mettant en œuvre, à titre de sous-couche sous-jacente à la couche catalytique, un empilement multicouche de couches alternées de silice et d'alumine selon l'invention.

Ainsi, l'invention concerne encore, selon un autre de ses aspects, un procédé de croissance d'un tapis de nanotubes de carbone, comprenant au moins les étapes consistant en :
(i) disposer d'un substrat muni sur au moins l'une de ses faces d'un empilement multicouche selon l'invention formé de couches alternées de silice et d'alumine, tel que décrit précédemment, ledit empilement multicouche étant revêtu en surface d'une couche catalytique ; et
(ii) procéder à la croissance d'un tapis de NTC à la surface de la couche catalytique, selon une technique de dépôt chimique en phase vapeur, assistée ou non par plasma, et de préférence activée par filament(s) chaud(s).

Les techniques de dépôt chimique en phase vapeur (connu sous l'acronyme anglais CVD de « Chemical Vapor Déposition ») sont des techniques bien connues pour la croissance de NTC.

D'une manière générale, le dépôt chimique en phase vapeur procède par la mise en phase vapeur d'un ou plusieurs précurseurs de carbone, suivie de la décomposition thermique des précurseurs en surface du catalyseur pour faire croître des NTC de carbone.

La croissance des NTC peut être opérée par une technique de dépôt chimique en phase vapeur assistée ou non par plasma.

Selon un mode de réalisation particulier, le procédé de croissance par CVD est opéré dans des conditions de basse pression.

Plus particulièrement, la pression au sein du réacteur CVD peut être maintenue à une valeur inférieure ou égale à 10 mbar, en particulier inférieure ou égale à 2 mbar et plus particulièrement comprise entre 0,5 et 1,5 mbar.

Selon une variante de réalisation particulièrement avantageuse, la croissance des NTC est opérée par une technique de CVD activée par filament(s) chaud(s) (acronyme anglais HFCVD pour « Hot Wire CVD »).

Il appartient à l'homme du métier d'ajuster les conditions de mise en œuvre du dépôt par CVD, en particulier par HFCVD, pour obtenir le tapis de NTC souhaité.

Le ou les filaments chauds peu(ven)t être en carbone (C), en ruthénium (Ru), en molybdène (Mo), en tantale (Ta), en rhénium (Re), en tungstène (W). De préférence, il s'agit de filament(s) en carbone.

La mise en œuvre de filament(s) chaud(s) en carbone pour la synthèse par CVD de nanotubes de carbone a déjà été décrite, par exemple par Chaisitsak *et al.* [5] et dans le document US 2006/0185595.

Le ou les filament(s) sont positionnés à proximité de la surface de la couche catalytique. Ils agissent à la fois comme source thermique pour la décomposition du gaz précurseur carboné, et peuvent également servir à chauffer le substrat.

Typiquement, le ou les filaments chauds sont positionnés parallèlement au plan formé par la surface de la couche catalytique, à une distance comprise entre 5 et 20 mm de la surface. Les filaments peuvent typiquement présenter une longueur allant de 5 à 25 cm et un diamètre compris entre 0,3 et 1 mm.

De préférence, plusieurs filaments sont mis en œuvre. Ils peuvent être avantageusement disposés parallèlement les uns des autres, sous la forme d'une grille, de préférence équidistants les uns des autres. Une telle grille de filaments chauds peut être par exemple telle que décrite dans le document US 2006/0185595. Il appartient à l'homme du métier d'optimiser, au regard du diamètre des filaments mis en œuvre, le nombre de filaments et l'espacement entre les filaments et la distance entre les filaments et la surface catalytique.

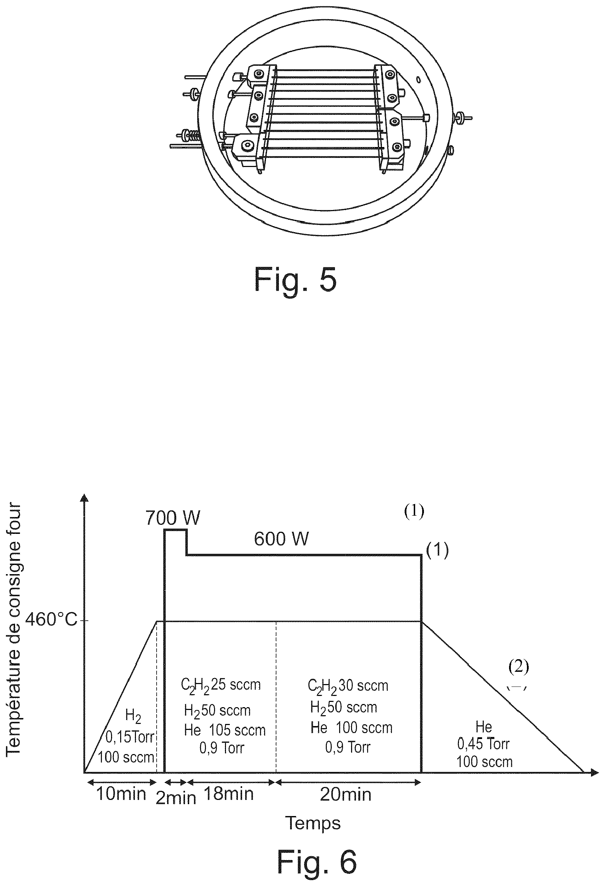

La figure 5 est une photographie de la grille de douze filaments en carbone mise en œuvre dans le procédé de croissance des NTC par HF-CVD dans les exemples qui suivent.

La puissance de filaments de carbone appliquée peut être comprise entre 100 et 2000 W, en particulier entre 400 et 1000 W. A cette puissance, la température des filaments de carbone est plus particulièrement comprise entre 1000 et 2500 °C, en particulier entre 1500 °C et 2000 °C.

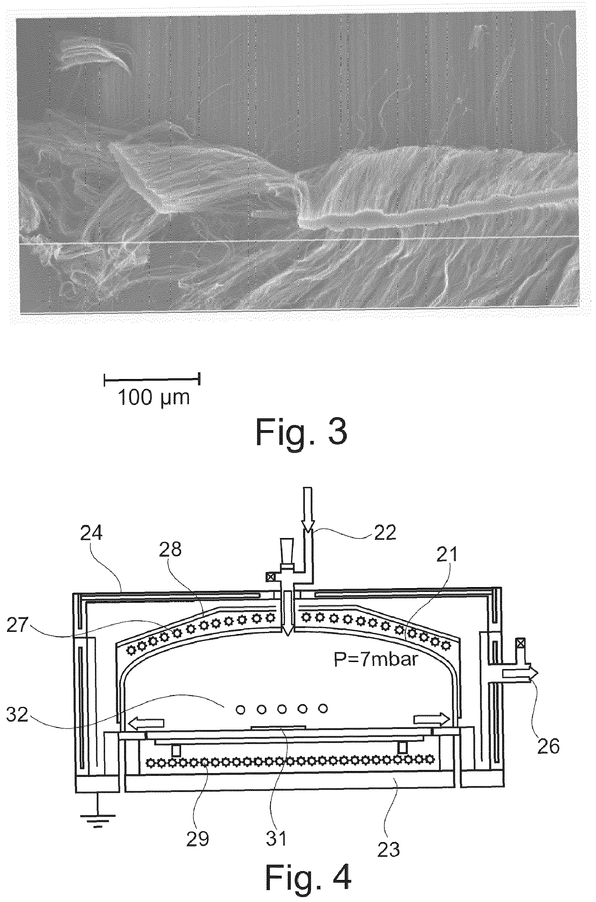

La croissance des NTCs peut être opérée au sein de tout réacteur adapté au dépôt chimique en phase vapeur. A titre d'exemple, la figure 4 est un schéma en coupe transversale d'une enceinte de dépôt permettant de mettre en œuvre le procédé selon l'invention.

Cette enceinte permet la réalisation d'un vide secondaire. Dans cette enceinte, une cloche en quartz (21) permet de limiter la zone réactionnelle où le plasma est réalisé. Cette cloche (21) permet l'introduction de gaz par une entrée de gaz (22). La cloche repose sur une sole (23) isolée électriquement du bâti (24). Une sortie de gaz (26) permet de pomper l'intérieur du bâti (24). Un premier dispositif de chauffage (27) est disposé au-dessus de la cloche (21) et sous un réflecteur thermique (28). Un deuxième dispositif de chauffage (29), placé en position basse permet de chauffer la sole au-dessus de laquelle repose l'échantillon (31).

Une grille de filaments chauds (32) peut être positionnée au-dessus de la surface de la couche catalytique de l'échantillon.

L'apport en carbone se fait grâce à un gaz précurseur riche en carbone, classiquement le méthane, l'éthane ou un alcène, en particulier l'éthylène, l'acétylène. De préférence, le précurseur carboné est de l'acétylène.

L'enceinte peut être placée sous atmosphère formée d'un ou plusieurs gaz, typiquement de l'hydrogène en mélange avec un ou plusieurs gaz neutres comme l'azote, l'argon ou l'hélium. La phase gazeuse carbonée peut être par exemple un mélange d'acétylène, d'hydrogène et d'hélium.

Bien entendu, le dispositif de dépôt par CVD peut comprendre, de manière classique, des moyens, non représentés en figure 4, permettant de contrôler le débit d'alimentation de l'enceinte.

Le flux gazeux en précurseur carboné peut être mis en œuvre avec un débit supérieur ou égal à 1 cm³/min (sccm), en particulier compris entre 20 et 40 cm³/min (sccm).

La mise en œuvre de filament(s) chaud(s) permet avantageusement d'opérer une synthèse des nanotubes de carbone par CVD à des températures plus basses que celles habituellement mises en œuvre dans des procédés de CVD.

De manière avantageuse, le procédé de croissance des NTC par CVD selon l'invention peut être réalisé dans des conditions de température strictement inférieure à 660 °C ; en particulier inférieure ou égale à 650 °C, et plus particulièrement inférieure ou égale à 640 °C et notamment d'environ 630 °C.

En particulier, les inventeurs ont constaté qu'il est possible, grâce à la mise en œuvre de filament(s) chaud(s), de préférence en carbone, d'accéder à un tapis de NTC, présentant les dimensions souhaitées, en termes de diamètre et de hauteur, avantageusement filables, dans des conditions de températures n'excédant pas 650 °C, et ce en contrôlant les paramètres lors de la croissance par CVD, comme détaillé dans la suite du texte.

Il est ainsi possible d'obtenir des tapis de NTC filables dans des conditions de températures plus basses que celles mises en œuvre dans les procédés de formation des NTC connus de la littérature, discutés précédemment, qui opèrent à partir d'une sous-couche support du catalyseur, de type silice ou alumine.

Ainsi, selon une variante de réalisation particulièrement avantageuse, la croissance des NTC par CVD assistée par filament(s) chaud(s) est opérée dans des conditions de pression inférieure ou égale à 1,5 mbar et de température inférieure ou égale à 650 °C, en particulier inférieure ou égale à 640 °C.

Plus particulièrement, il est procédé à la croissance des NTC par CVD assisté par filament(s) chaud(s), en faisant varier au cours de la croissance des NTC l'apport en carbone en surface du catalyseur.

L'ajustement de l'apport en carbone en surface du catalyseur peut être opéré en faisant varier le débit gazeux en précurseurs carbonés.

Plus particulièrement, le débit gazeux en carbone, typiquement compris entre 20 et 40 cm³/min (sccm), peut être augmenté, au cours de la croissance des NTC d'au moins de 20 %, en particulier de l'ordre de 20 à 40 %, par rapport à sa valeur initiale au début de la croissance des NTC.

Le contrôle de l'apport en carbone en surface du catalyseur permet avantageusement un ajustement des paramètres de croissance, malgré la dérive en température induite par l'apport en puissance du ou des filament(s) chaud(s).

Par ailleurs, il est avantageusement procédé à la croissance des NTC par CVD assisté par filament(s) chaud(s), en faisant varier au cours de la croissance des NTC la puissance du ou des filament(s).

Plus particulièrement, la puissance de filament(s) est ajustée de manière à être plus élevée au début de la phase de croissance des NTC que par la suite.

Par exemple, la puissance peut être abaissée quelques minutes après le début du procédé par CVD, notamment être diminuée de 10 à 20 % par rapport à sa valeur initiale au début du procédé de CVD.

Un tel ajustement de la puissance de filament(s) permet avantageusement de limiter la dérive en température, et d'obtenir une nucléation rapide du tapis.

Ainsi, selon une variante de réalisation particulièrement avantageuse, la croissance du tapis de NTC par un procédé CVD assisté par filament(s) chaud(s) est opérée en faisant varier au cours de la croissance par CVD, à la fois l'apport en carbone en surface du catalyseur et la puissance du ou des filament(s) chauds.

La durée de croissance des NTC peut être comprise entre 10 et 60 minutes, en particulier entre 20 et 50 minutes.

Bien entendu, l'invention n'est nullement limitée à la mise en œuvre d'un dépôt par CVD assisté par filament(s) chaud(s) dans les conditions décrites ci-dessus, de basse pression et de basse température. D'autres variantes pour la croissance par CVD des nanotubes de carbone en surface d'une structure multicouche selon l'invention peuvent être mises en œuvre.

Par exemple, la croissance des NTC peut être opérée selon d'autres techniques de croissance en CVD classiques, comme par exemple suivant des procédés opérés dans des fours à pression atmosphérique.

### TAPIS DE NTC ET APPLICATIONS

L'ensemble obtenu à l'issue de la formation du tapis de NTC comprend plus particulièrement, l'empilement suivant, dans cet ordre :
- substrat de base tel que défini précédemment ;
- empilement multicouche selon l'invention formé de couches alternées de silice et d'alumine ;
- couche de matériau(x) catalyseur(s) de la croissance de nanotubes de carbone, en particulier en fer ; et
- tapis de NTC.

Les nanotubes d'un tapis de NTC obtenu selon l'invention peuvent être plus particulièrement obtenus sous forme d'un seul feuillet, aussi appelés SWNT (pour « Single Wall Carbon Nanotubes » en langue anglaise) et/ou de multi-feuillets, aussi appelés MWNT (pour « Multi Wall Carbon Nanotubes » en langue anglaise).

Un tapis de NTC obtenu selon l'invention comporte en particulier des nanotubes de carbone présentant un diamètre unitaire moyen compris entre 4 et 10 nm, de préférence inférieur ou égal à 8 nm, et plus particulièrement inférieur ou égal à 7 nm.

Le diamètre des NTC peut être estimé par microscopie électronique à transmission.

De manière avantageuse, les tapis de NTC formés selon l'invention présentent de bonnes propriétés de filabilité. En particulier, les NTC présentent des hauteurs adaptées pour le filage des tapis obtenus. La longueur des nanotubes de carbone d'un tapis de NTC selon l'invention peut être supérieure ou égale à 100 µm, en particulier comprise entre 100 et 600 µm, en particulier entre 100 et 400 µm et plus particulièrement entre 150 et 300 µm.

Un tapis de NTC formé selon l'invention peut présenter avantageusement une densité en NTC supérieure ou égale à 10¹⁰, en particulier compris entre 10¹⁰ et 10¹¹ NTC par cm².

Comme indiqué précédemment, le procédé de l'invention permet avantageusement d'accéder à un tapis de nanotubes de carbone, avantageusement filables, présentant de bonnes performances électriques.

Les performances électriques d'un tapis de NTC peuvent être appréciées au regard de la conductivité électrique des câbles fabriqués à partir du tapis de NTC.

Ainsi, la conductivité des câbles fabriqués à partir d'un tapis de nanotubes de carbone réalisé selon l'invention est avantageusement supérieure ou égale à 600 S/cm, en particulier supérieure ou égale à 900 S/cm, et notamment d'environ 926 S/cm.

Les tapis de nanotubes de carbone, en particulier filables, obtenus selon l'invention, présentant de bonnes propriétés électriques, trouvent des applications particulièrement avantageuses, notamment mis en œuvre sous la forme de films 2D (nappes) ou de câbles.

Les câbles à base de nanotubes de carbone peuvent être utilisés pour des applications dans l'aéronautique et l'aérospatiale.

Du fait de leurs excellentes propriétés mécaniques et électriques, les nanotubes de carbone peuvent encore être mis en œuvre dans la fabrication de capteurs de pression et de capteurs de gaz.

Les nappes de nanotubes de carbone trouvent enfin de nombreuses applications pour la réalisation d'électrodes transparentes conductrices qui sont comprises dans des dispositifs d'affichage (OLED, écrans tactiles, écrans flexibles, etc.), des dispositifs photovoltaïques, par exemple dans des cellules solaires. Elles peuvent encore être mises en œuvre dans la préparation de divers dispositifs électroniques ou optoélectroniques.

L'invention va maintenant être décrite au moyen des exemples suivants, donnés bien entendu à titre illustratif et non limitatif de l'invention.

### EXEMPLE

### Préparation des sous-couches

Les échantillons sont préparés à partir d'un wafer de silicium, sur lequel un empilement multicouche spécifique selon l'invention est formé *via* un procédé de dépôt de couches minces atomiques (ALD).

Une couche de catalyseur de fer d'épaisseur de 1,5 nm est ensuite déposée à la surface de l'empilement par évaporation par canon à électrons.

Les empilements multicouches testés sont composés de 10 % molaire d'alumine et de 90 % molaire de silice. L'épaisseur totale (E) de chacun des empilements multicouches est de 10 nm. Une monocouche de silice ou d'alumine a une épaisseur d'environ 0,1 nm. L'empilement obtenu d'une épaisseur de 10 nm est constitué d'environ 100 monocouches atomiques avec 90 monocouches atomiques de silice et 10 monocouches atomiques d'alumine

Tout en conservant ces proportions en silice et en alumine, trois empilements multicouches, présentant des distributions différentes des monocouches atomiques de silice et d'alumine, ont été préparés, comme représentés schématiquement en figure 2.
Empilement 1 : alternance d'une monocouche atomique d'alumine (Al₂O₃) et de neuf monocouches atomiques de silice (Si02), la couche supérieure étant une couche de silice ;
Empilement 2 : alternance de neuf monocouches atomiques de silice (SiO₂) et d'une monocouche atomique d'alumine (Al₂O₃), la sous-couche supérieure étant une couche d'alumine ; et
Empilement 3 : répétition de la séquence suivante : quatre monocouches atomiques de silice/une monocouche atomique d'alumine/cinq monocouches atomiques de silice, la couche supérieure étant une couche d'alumine.

### Procédé de croissance des nanotubes de carbone par CPCVD assisté par filaments chauds

La croissance des tapis de nanotubes de carbone est opérée dans un réacteur CVD assisté par filaments chauds, comme représenté en figure 4 suivante, selon les étapes successives suivantes.

Tout d'abord, après installation des échantillons dans le réacteur, le vide est effectué jusqu'à une pression de 5.10⁻⁶ Torr.

Ensuite, sous un flux de 100 sccm d'hydrogène à 0,15 Torr, la température du four est élevée jusqu'à 460°C en 10 minutes.

La température du four est ensuite maintenue à 460 °C, puis la phase gazeuse est changée en 25 sccm d'acétylène, 50 sccm d'hydrogène et 105 sscm d'hélium à 0,9 Torr.

Simultanément au changement des gaz, une « raquette » formée de six filaments en carbone (10 cm de longueur et 0,4 ou 0,5 mm de diamètre), installés en parallèle, et positionnés à 1 cm au-dessus de l'échantillon, sont allumés, avec une puissance de 700 W pendant 2 minutes puis de 600W pendant les 18 minutes suivantes.

La phase gazeuse est ensuite enrichie en carbone avec 30 sccm d'acétylène, 50 sccm d'hydrogène et 100 sccm d'hélium à 0,9 Torr pendant les 20 minutes suivante. La température de consigne du four et la puissance des filaments restent inchangées.

La puissance des filaments est ensuite coupée, ainsi que le chauffage du four ; la phase gazeuse est alors uniquement formée d'hélium à 0,45 Torr avec un débit de 100 sccm.

Le chronogramme des paramètres du procédé de croissance des NTC est représenté en figure 6, avec (1) la puissance des filaments chauds et (2) la température de la sole du réacteur sur laquelle repose les échantillons.

### Résultats

Les trois empilements, mis en œuvre à titre de sous-couche support du catalyseur de fer dans le procédé de croissance des NTC par HF-CVD, ont conduit à la formation de tapis présentant des propriétés de filabilité.

La figure 3 présente une photographie obtenue par microscopie électronique à balayage (MEB) d'un des tapis de NTC obtenu avec l'empilement 1.

La cinétique de croissance des NTC est différente suivant les sous-couches mises en œuvre. Ainsi, avec un procédé de croissance identique de 40 minutes, tel que décrit précédemment, les nanotubes de carbone obtenus présentent, une longueur moyenne de 185 µm avec l'empilement 1, de 250 µm avec l'empilement 2 et de 290 µm avec l'empilement 3.

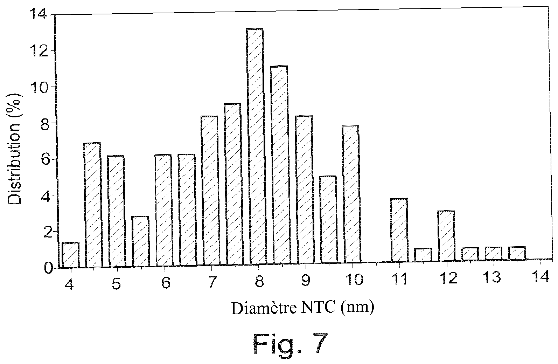

Le diamètre moyen des nanotubes est de 7 nm. La distribution des diamètres des NTC obtenus avec les trois sous-couches testées est représentée en figure 7.

Il est ainsi possible, en ajustant le nombre et la distribution des monocouches atomiques de silice et d'alumine au sein d'un empilement multicouche selon l'invention, de contrôler les paramètres de croissance, et les dimensions des nanotubes de carbone obtenus.

Les câbles préparés à partir des tapis de NTC obtenus présentent une conductivité électrique de 926 S/cm. Le câble en nanotubes de carbone est fabriqué à partir d'un tapis de nanotubes de carbone « filable ». Ce tapis se débobine en nappe que l'on vient ensuite torsader et embobiner sur une bobine. Les mesures de conductivité électriques de ce câble sont faites avec la méthode quatre pointes. Le diamètre du câble, mesuré avec un microscope optique, est d'environ 10 µm.

### Références

[1] Zhang et al., Science. 309 (2005) 1215-1219 ;
[2] Di et al., ACS Nano. 6 (2012) 5457-5464 ;
[3] Liu et al., Nanoscale. 4 (2012) 3389 ;
[4] Todri-Sanial et al., Carbon Nanotubes for Internconnects : Process, Design and Applications, Springer International Publishing, 2017;
[5] Chaisitsak et al., Diamond and Related Materials 13 (2004), 438-444.

## Revendications

1. Utilisation, à titre de sous-couche support du catalyseur dans un procédé de croissance de nanotubes de carbone par dépôt chimique en phase gazeuse, d'un empilement multicouche (1) formé de couches alternées de silice (12) et d'alumine (11), chacune des couches présentant une épaisseur inférieure ou égale à 10 nm et étant constituée d'une ou plusieurs monocouche(s) atomique(s) superposée(s).

2. Utilisation selon la revendication précédente, lesdites couches de silice, formées d'une ou plusieurs monocouches atomiques de silice, présentant, indépendamment les unes des autres, une épaisseur (e_{Si}) comprise entre 0,01 et 10 nm, en particulier entre 0,1 et 10 nm et plus particulièrement entre 0,1 et 2 nm ; et/ou
lesdites couches d'alumine, formées d'une ou plusieurs monocouches atomiques d'alumine, présentant, indépendamment les unes des autres, une épaisseur (e_{Al}) comprise entre 0,01 et 10 nm, en particulier entre 0,1 et 10 nm et plus particulièrement entre 0,1 et 2 nm.

3. Utilisation selon l'une quelconque des revendications précédentes, lesdites couches d'alumine étant formées, indépendamment les unes des autres, de 1 à 500, en particulier de 10 à 500 monocouche(s) atomique(s) d'alumine ; et/ou lesdites couches de silice étant formées, indépendamment les unes des autres, de 1 à 500, en particulier de 10 à 500 monocouche(s) atomique(s) de silice.

4. Utilisation selon l'une quelconque des revendications précédentes, ledit empilement multicouche présentant une épaisseur totale (E) comprise entre 5 et 50 nm, en particulier entre 7 et 20 nm, et plus particulièrement entre 8 et 12 nm.

5. Utilisation selon l'une quelconque des revendications précédentes, ledit empilement multicouche présentant un ratio molaire silice/alumine compris entre 1 et 99, en particulier entre 2 et 50, et plus particulièrement entre 5 et 15, notamment de 9.

6. Structure multicouche (2) comportant un substrat (10) muni sur au moins l'une de ses faces d'un empilement multicouche (1) tel que défini dans l'une quelconque des revendications 1 à 5, ledit empilement multicouche (1) étant revêtu, sur sa face opposée au substrat, d'une couche (13) de matériau(x) catalyseur(s) de la croissance des nanotubes de carbone, dite couche catalytique, en particulier en fer.

7. Procédé de préparation d'une structure multicouche (2) telle que définie selon la revendication 6, comprenant le dépôt, en surface d'un substrat de base (10), de monocouches successives atomiques de silice et d'alumine pour former ledit empilement multicouche (1) ; et le dépôt, sur la face dudit empilement multicouche opposée au substrat de base, d'une couche de matériau(x) catalyseur(s) de la croissance des nanotubes de carbone.

8. Procédé selon la revendication précédente, dans lequel lesdites monocouches atomiques de silice et d'alumine de l'empilement multicouche sont formées par une technique de dépôt de couches atomiques ALD.

9. Procédé de croissance d'un tapis de nanotubes de carbone, de préférence filables, comprenant au moins les étapes consistant en :
(i) disposer d'un substrat (10) muni sur au moins l'une de ses faces d'un empilement multicouche (1) formé de couches alternées de silice et d'alumine, tel que défini dans l'une quelconque des revendications 1 à 5, ledit empilement multicouche (1) étant revêtu en surface d'une couche catalytique (13) ; et
(ii) procéder à la croissance, en surface de la couche catalytique, d'un tapis de nanotubes de carbone, selon une technique de dépôt chimique en phase vapeur, assistée ou non par plasma, et de préférence activée par filament(s) chaud(s).

10. Procédé selon la revendication précédente, dans lequel la croissance des nanotubes de carbone par dépôt chimique en phase vapeur est assistée par filament(s) chaud(s), de préférence par une grille de filaments chauds positionnée au-dessus de la surface de la couche catalytique, lesdits filaments chauds étant de préférence des filaments en carbone ; la croissance des nanotubes de carbone par dépôt chimique en phase vapeur étant plus particulièrement opérée dans des conditions de pression inférieure ou égale à 10 mbar et de température inférieure ou égale à 650 °C.

11. Procédé selon la revendication 10, dans lequel l'on fait varier, au cours de la croissance des nanotubes de carbone, l'apport en carbone en surface du catalyseur, en particulier en faisant varier le débit gazeux en précurseurs carbonés.

12. Procédé selon l'une quelconque des revendications 10 et 11, dans lequel l'on fait varier, au cours de la croissance des nanotubes de carbone en étape (ii), la puissance du ou des filament(s) chaud(s), en particulier entre 400 et 1000 W.

13. Ensemble comportant une structure multicouche telle que définie selon la revendication 6, revêtue d'un tapis de nanotubes carbone, en particulier d'un tapis de nanotubes de carbone filables.

14. Ensemble selon la revendication précédente, obtenu à l'issue du procédé tel que défini selon l'une quelconque des revendications 9 à 12.

15. Ensemble selon la revendication 13 ou 14, dans lequel les nanotubes de carbone présentent un diamètre moyen inférieur ou égal à 13 nm, en particulier inférieur ou égal à 8 nm, et plus particulièrement inférieur ou égal à 7 nm ; et/ou une longueur moyenne supérieure ou égale à 100 µm, en particulier comprise entre 100 et 600 µm, et plus particulièrement comprise entre 150 et 300 µm.
